# EUROPEAN PATENT APPLICATION

(11) **EP 4 610 685 A1**
(43) Date of publication of application: **03.09.2025**
(21) Application number: 23882763.8
(22) Date of filing: 27.10.2023
(51) Int. Cl.: G01R 33/032

(54) **MAGNETIC FILM AND MAGNETIC FIELD SENSOR HEAD**

(30) Priority: 28.10.2022 JP 2022173702
(71) Applicant: CITIZEN FINEDEVICE CO., LTD., Minamitsuru-gun, Yamanashi 401-0395 (JP); Citizen Watch Co., Ltd., Nishitokyo-shi, Tokyo 188-8511 (JP); Shinshu University, Matsumoto-shi, Nagano 390-8621 (JP)
(72) Inventor: SUE, Satoshi, Minamitsuru-gun, Yamanashi 401-0395 (JP); MIYAMOTO, Mitsunori, Minamitsuru-gun, Yamanashi 401-0395 (JP); KUBO, Toshiya, Minamitsuru-gun, Yamanashi 401-0395 (JP); AIBA, Tetsuya, Minamitsuru-gun, Yamanashi 401-0395 (JP); SATO, Toshiroh, Nagano-shi, Nagano 380-8553 (JP); SONEHARA, Makoto, Nagano-shi, Nagano 380-8553 (JP)
(74) Representative: Ricker, Mathias
(86) International application number: PCT/JP2023/038907
(87) International publication number: WO 2024/090561

(57) **Abstract**

A magnetic sensor head includes an optical fiber, a GI fiber having one end optically connected to the optical fiber, a magnetic film joined to the other end of the GI fiber, and a reflective film joined to a surface of the magnetic film opposite a surface joined to the GI fiber. The magnetic film is formed of a rare-earth iron garnet film. The slope of the sum of squared differences of the rare-earth iron garnet film with respect to an applied magnetic field is 100 or greater.

## Description

### FIELD

The present disclosure relates to a magnetic field sensor head and a magnetic film.

### BACKGROUND

A known magnetic field sensor includes a polarization maintaining fiber (PMF) and a magnetic field sensor head in which rare-earth iron garnet is used as a magnetic film (e.g., WO2022/107431A).

In the above magnetic field sensor, the size of striped magnetic domains of rare-earth iron garnet is close to the core diameter (10 µm) of the PMF, so that the PMF and the magnetic field sensor head are coupled via a graded-index (GI) fiber. With this structure, a beam emitted from the PMF can be expanded in diameter to 20 µm using the GI fiber to irradiate the rare-earth iron garnet, making it possible to capture magnetic domain reversal.

### SUMMARY

However, since the size of striped magnetic domains of rare-earth iron garnet varies depending on the structure of the garnet crystal, good measurements cannot be made unless the garnet crystal and the diameter of a beam emitted from the PMF are properly matched.

The present disclosure has been made to solve the above problem, and has an object to provide a magnetic field sensor head and a magnetic film that enable good measurements.

A magnetic sensor head of an embodiment of the present disclosure includes an optical fiber, a GI fiber having one end optically connected to the optical fiber, a magnetic film joined to the other end of the GI fiber, and a reflective film joined to a surface of the magnetic film opposite a surface joined to the GI fiber. The magnetic film is formed of a rare-earth iron garnet film. The slope of the sum of squared differences of the rare-earth iron garnet film with respect to an applied magnetic field is 100 or greater.

In the above magnetic sensor head, the thickness of the rare-earth iron garnet film is preferably between 51 µm and 126 µm inclusive.

In the above magnetic sensor head, the diameter of a beam emitted from the GI fiber to the magnetic film is preferably between 30 µm and 100 µm inclusive.

A magnetic film of an embodiment of the present disclosure is used for a magnetic sensor head including an optical fiber, a GI fiber having one end optically connected to the optical fiber, and a reflective film, and has one surface joined to the GI fiber and the other surface joined to the reflective film. The magnetic film is formed of a rare-earth iron garnet film. The slope of the sum of squared differences of the rare-earth iron garnet film with respect to an applied magnetic field is 100 or greater.

The magnetic field sensor head and the magnetic film of the present disclosure enable good measurements of a magnetic field.

### BRIEF DESCRIPTION OF DRAWINGS

FIG. 1 is a schematic block diagram showing a magnetic field sensor device 1;
FIG. 2 is a cross-sectional view of a first PMF 31 taken along line A-A shown in FIG. 1;
FIG. 3(a) is a plane photograph of a magnetic film 34, and (b) shows the positional relationship between the first PMF 31 and the magnetic film 34;
FIGs. 4(a), (b), and (c) are plane photographs showing striped magnetic domains of a 51-µm-thick magnetic film, an 89-µm-thick magnetic film, and a 126-µm-thick magnetic film, respectively;
FIG. 5 shows a measurement method of the sum of squared differences;
FIGs. 6(a) to (c) show the sum of squared differences of the 51-µm-thick magnetic film with respect to an applied magnetic field for the case where the field of view is varied;
FIGs. 7 (a) to (c) show the sum of squared differences of the 89-µm-thick magnetic film with respect to an applied magnetic field for the case where the field of view is varied;
FIGs. 8(a) to (c) show the sum of squared differences of the 126-µm-thick magnetic film with respect to an applied magnetic field for the case where the field of view is varied; and
FIG. 9 shows evaluations of the magnetic films.

### DESCRIPTION OF EMBODIMENTS

Various embodiments of the present invention will now be described with reference to the drawings. It should be noted that the technical scope of the present invention is not limited to these embodiments, but extends to the inventions described in the claims and their equivalents.

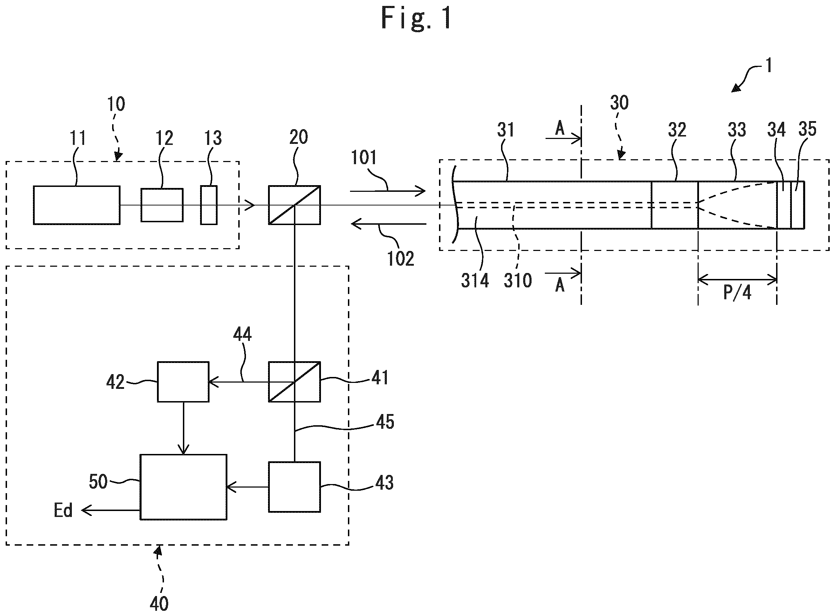

FIG. 1 is a schematic block diagram showing a magnetic field sensor device 1 in which a magnetic field sensor head 30 with a magnetic film of an embodiment is used.

The magnetic field sensor device 1 includes a light emitter 10, an optical splitter 20, a magnetic field sensor head 30, and a detection signal generator 40.

The light emitter 10 includes a light-emitting element 11, an isolator 12, and a polarizer 13. The light-emitting element 11 is, for example, a semiconductor laser or a light-emitting diode. Specifically, a Fabry-Perot laser, a superluminescent diode, or the like can be preferably used as the light-emitting element 11.

The isolator 12 transmits light incident from the light-emitting element 11 toward the optical splitter 20, and does not transmit light incident from the optical splitter 20 toward the light-emitting element 11, thereby protecting the light-emitting element 11. The isolator 12 is, for example, a polarization-dependent optical isolator, but may be a polarization-independent optical isolator.

The polarizer 13 is an optical element for polarizing light emitted by the light-emitting element 11 to linearly polarized light, and the type thereof is not particularly limited. The linearly polarized light obtained by the polarizer 13 is incident on the magnetic field sensor head 30 via the optical splitter 20 as incident light 101.

The optical splitter 20 transmits light emitted from the light emitter 10 to the magnetic field sensor head 30, and makes part of return light 102 emitted from the magnetic field sensor head 30 split off toward the detection signal generator 40. The directions of transmission and splitting may be interchanged. The optical splitter 20 is, for example, a half mirror, but may be another optical element capable of splitting light, such as an optical coupler that couples or splits optical fibers, a beam splitter that splits light, and an optical circulator.

The magnetic field sensor head 30 includes a first PMF 31, a second PMF 32, a GI fiber 33, a magnetic film 34, and a reflective film 35. At least part of the magnetic field sensor head can be placed within a given magnetic field. The magnetic field sensor head 30, into which linearly polarized light emitted by the light emitter 10 is introduced as the incident light 101, outputs the return light 102 depending on the introduced incident light 101.

The detection signal generator 40 includes a polarization separation element 41, a first light-receiving element 42, a second light-receiving element 43, and a signal processor 50, and receives the return light 102 outputted from the first PMF 31. The polarization separation element 41 is a polarization beam splitter (PBS) of a prism type, a flat type, a wedge substrate type, an optical waveguide type, or the like, and separates the return light 102 outputted from the first PMF 31 into an S-polarized light component 44 and a P-polarized light component 45.

The first and second light-receiving elements 42 and 43 are each, for example, a PIN photodiode. The first light-receiving element 42 receives the S-polarized light component 44, and the second light-receiving element 43 receives the P-polarized light component 45. The first and second light-receiving elements 42 and 43 each photoelectrically convert the received light to output an electrical signal depending on the amount of the received light.

The signal processor 50 detects the difference in intensity between the two polarized light components from the electrical signals photoelectrically converted by the first and second light-receiving elements 42 and 43, converts the detected numerical value into a current value, and outputs the current value as a detection signal Ed. The detection signal Ed reflects the intensity of the magnetic field in which the magnetic field sensor head 30 is placed.

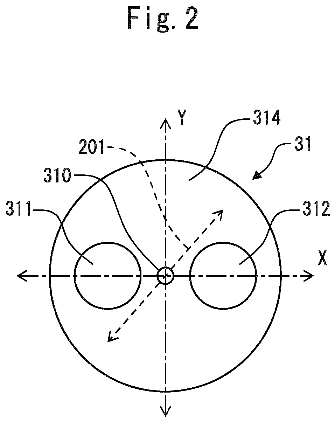

FIG. 2 is a cross-sectional view of the first PMF 31 taken along line A-A shown in FIG. 1.

The first polarization maintaining fiber (PMF) 31 is a polarization-maintaining and absorption-reducing (PANDA) fiber, and has a core 310, a pair of stress-applying portions 311 and 312, and a cladding 314. The core 310 is formed, for example, by doping silicon dioxide with germanium dioxide (GeO₂) so that the core has a higher refractive index than the cladding 314 formed of silicon oxide (SiO₂). The pair of stress-applying portions 311 and 312 is each formed, for example, by doping silicon dioxide with boron oxide (B₂O₃), and contracts more than the cladding 314 during the cooling process of spinning of the first PMF 31, thereby applying tensile stress in the X-axis direction.

The first PMF 31 is disposed so that the polarization plane 201 of the incident light 101 introduced from the light emitter 10 via the optical splitter 20 is inclined 45 degrees with respect to both the X-axis, which is the slow axis, and the Y-axis, which is the fast axis. By being disposed with the X- and Y-axes inclined 45 degrees with respect to the polarization plane 201 of the introduced incident light 101, the first PMF 31 separates the introduced incident light 101 into a first linearly polarized wave propagating along the X-axis and a second linearly polarized wave propagating along the Y-axis. The amplitude of the first linearly polarized wave introduced into the X-axis is equal to that of the second linearly polarized wave introduced into the Y-axis.

The first PMF 31 is a PANDA fiber, but may be another PMF, such as a bowtie fiber and an elliptic jacket fiber.

The second PMF 32, like the first PMF 31, is a PANDA fiber. The configuration of the second PMF 32 is similar to that of the first PMF 31, so that a detailed description thereof will be omitted herein. The second PMF 32 has the same core diameter and cladding diameter as the first PMF 31.

The second PMF 32 is optically connected to the first PMF 31 with its second slow axis and second fast axis inclined 45 degrees with respect to the slow axis and the fast axis of the first PMF 31. The second PMF 32 is connected to the first PMF 31, for example, by fusion splicing. The second PMF 32 may be connected to the first PMF 31 by a connection method other than fusion splicing, such as connection via an adhesive. As described in WO2022/107431A, the second PMF 32 has a length of one-quarter of the beat length, thereby functioning as a quarter wave plate.

The GI fiber 33 is an optical fiber whose core has refractive indices radially distributed to transmit light introduced into the core from the second PMF 32 as a sine wave having a period of pitch P. One end of the GI fiber 33 is optically connected to the first PMF 31 via the second PMF 32. The GI fiber 33 has the same cladding diameter as the first PMF 31 and the second PMF 32.

The GI fiber 33 has a length of one-quarter of the pitch P, and thereby outputs light introduced from the second PMF 32 to the magnetic film 34 as collimated light. The GI fiber also outputs collimated light introduced from the magnetic film 34 to the core of the second PMF 32.

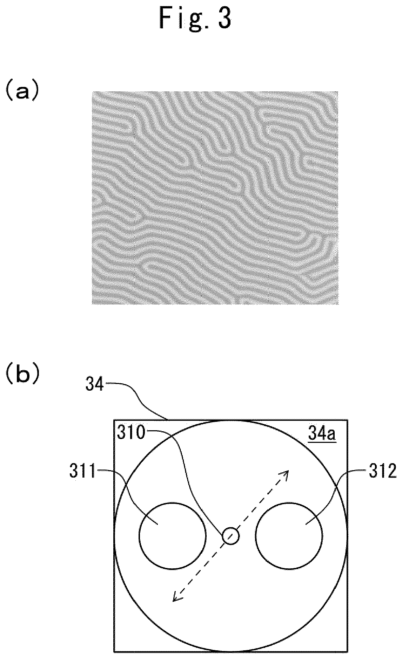

FIG. 3(a) is a plane photograph of the magnetic film 34, and FIG. 3(b) shows the positional relationship between the first PMF 31 and the magnetic film 34.

A surface 34a of the magnetic film 34 has a flat square shape, and is joined to the other end of the GI fiber 33 by being bonded to the other end of the GI fiber 33 with an adhesive (not shown). The surface of the magnetic film 34 opposite the surface joined to the GI fiber 33 is joined to one surface of the reflective film 35.

As shown in FIG. 3(b), the length of one side of the surface 34a of the magnetic film 34 is 125 µm, which is the same as the cladding diameter of the GI fiber 33. The magnetic film 34 is disposed so that the center of the surface 34a coincides with that of the GI fiber 33. Since the length of one side of the surface 34a of the magnetic film 34 is the same as the cladding diameter of the GI fiber 33 and the center of the surface 34a coincides with that of the GI fiber 33, the magnetic film 34 is disposed so that the outer rim of the GI fiber 33 touches the centers of the sides of the surface 34a internally.

The reflective film 35 is a mirror element that reflects light transmitted through the magnetic film 34 toward the magnetic film 34 to generate the return light 102. The reflective film 35 emits circularly polarized light that is opposite in direction of rotation to the circularly polarized light transmitted through the magnetic field sensor head 30, to the magnetic film 34. As the reflective film 35 may be used, for example, a silver (Ag) film, a gold (Au) film, an aluminum (Al) film, or a dielectric multilayer mirror. In particular, a Ag film having a high reflectance and a Au film having a high corrosion resistance are preferable because they can be easily formed. The reflective film 35 may have any thickness that ensures a sufficient reflectance of 98% or more. For example, in the case of a Ag film, the thickness is preferably between 50 nm and 200 nm inclusive. The reflective film 35 is used to make light travel back and forth within the magnetic film 34, enabling the Faraday rotation angle to be increased.

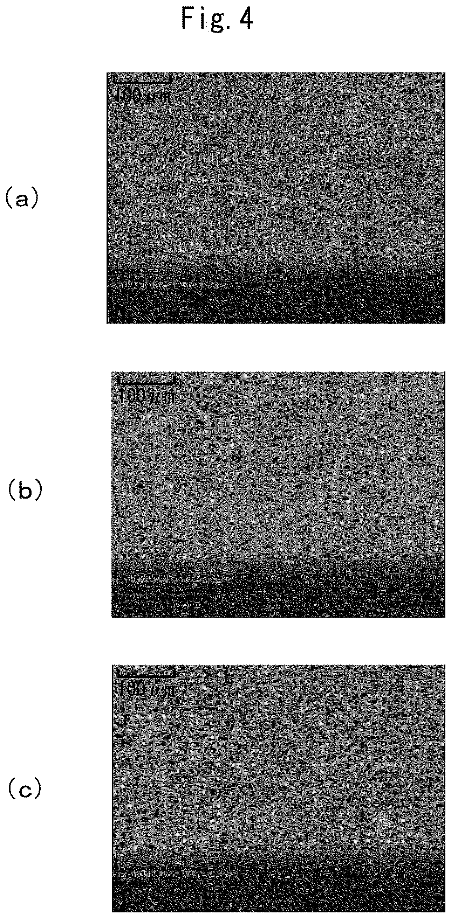

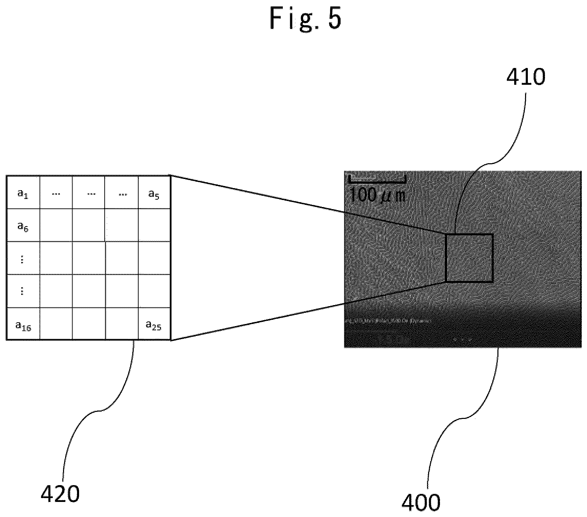

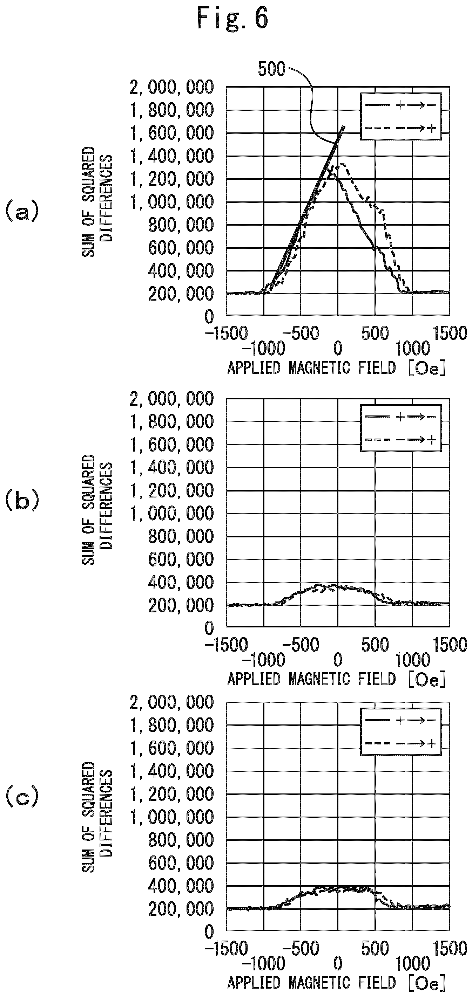

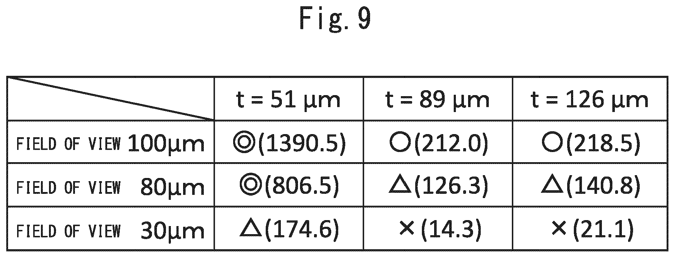

FIG. 4 is plane photographs showing striped magnetic domains depending on the thickness of the magnetic film. FIG. 5 shows a measurement method of the sum of squared differences. FIGs. 6 to 8 show the sum of squared differences of the magnetic films with respect to an applied magnetic field for the case where the thickness and the field of view are changed. FIG. 9 shows evaluations of the magnetic films. Using FIGs. 4 to 9, the relationship between the diameter of a beam outputted from the GI fiber 33 and the thickness of the magnetic film 34 will be discussed below.

The magnetic film of the embodiment is a single-crystal thin film having a garnet-type crystal structure represented by the composition formula RₓY₃₋ₓFe₅O₁₂ in which rare-earth iron garnet is substituted with Y (hereafter simply a "rare-earth iron garnet film"). R is a rare-earth metal and is an element that can be substituted for Y. The magnetic film 34 of the magnetic field sensor head 30 functions as a Faraday rotator that changes the phase of circularly polarized light emitted from the GI fiber 33 according to the magnetic field in which the magnetic field sensor element is placed.

The core diameter of the first PMF 31 and the second PMF 32 is about 10 µm. If the beam of the incident light 101 is outputted from the core of the second PMF 32 directly to the magnetic film 34, optical modulation caused by magnetization may not occur properly unless the beam diameter can properly capture the striped magnetic domains of the magnetic film 34. It is therefore necessary to increase the diameter of the beam outputted to the magnetic film 34 with the GI fiber 33 to achieve proper optical modulation.

FIGs. 4(a), 4(b), and 4(c) show striped magnetic domains of a 51-µm-thick magnetic film, an 89-µm-thick magnetic film, and a 126-µm-thick magnetic film, respectively. Each of the magnetic films in FIGs. 4(a) to (c) is the same as the rare-earth iron garnet film mentioned above, and no magnetic field is applied to any of them.

As shown in FIGs. 4(a) to (c), it can be understood that the size of the striped magnetic domains increases with the thickness of the magnetic film. FIGs. 4(a) to (c) show the state in which no magnetic field is applied, as mentioned above. However, when a magnetic field is applied, the size of the striped magnetic domains varies depending on the applied magnetic field. Thus, in the magnetic sensor head, it is necessary to select a beam diameter suitable for the striped magnetic domains depending on the thickness of the magnetic film.

FIG. 5 shows a measurement method of the sum of squared differences. In FIG. 5, a square field of view 410 is set on the plane of a given magnetic film 400. The field of view 410 corresponds to the diameter of a beam inscribed exactly within the field of view. Specifically, when the field of view is 100 µm, the diameter of a beam outputted directly from the GI fiber 33 to the magnetic film 34 is 100 µm.

When measuring the sum of squared differences, the field of view 410 of an image of striped magnetic domains in a given magnetic field is divided into N×N sections 420, and Σ(a₍ₙ₊₁₎-aₙ)² is calculated to obtain the value of the sum of squared differences. aₙ shows the brightness value of each section in the image of striped magnetic domains. The brightness values of an image used at measuring the sum of squared differences are 8-bit values ranging from 0 to 255. In FIG. 5, the image is divided into 5×5=25 sections; but this is just an example, and the image may be divided into a different number of sections.

FIG. 5 shows the state in which no magnetic field is applied, similarly to FIG. 4(a). However, the magnetic field is changed from -1500 (Oe) to +1500 (Oe), and the sum of squared differences is calculated based on an image of striped magnetic domains in the field of view for each given magnetic field. Further, the sum of squared differences is measured in two cases: when the magnetic field is changed from -1500 (Oe) to +1500 (Oe), and when it is changed from +1500 (Oe) to -1500 (Oe).

In the measurements of the sum of squared differences, a rare-earth iron garnet film of a given thickness with dimensions of approximately 1000 µm in length and width was prepared, and a video of striped magnetic domains was recorded when the magnetic field was changed from -1500 (Oe) to +1500 (Oe). From the recorded video, still images were taken for each given magnetic field, and the sum of squared differences was calculated based on the method described above.

FIG. 6 shows the case where a 51-µm-thick rare-earth iron garnet film is used. FIGs. 6(a), 6(b), and 6(c) show graphs of the sum of squared differences with respect to the applied magnetic field for the cases where the field of view is 100 µm, 80 µm, and 30 µm, respectively.

In FIGs. 6(a) to 6(c), the graphs for the case of change from +1500 (Oe) to -1500 (Oe) are shown with solid lines, and the graphs for the case of change from -1500 (Oe) to +1500 (Oe) are shown with broken lines. The sum of squared differences in FIGs. 6(a) to (c) is measured as shown in FIG. 5, and calculated on 5x5=25 sections.

In FIG. 6(a), a straight line 500 that approximates the portion from -800 (Oe) to 0 (Oe) of the graph for the case of change from +1500 (Oe) to -1500 (Oe) is y=1390.5x+1E+06. In FIGs. 6(b), 6(c), 7, and 8 below, illustration of approximate lines will be omitted.

In FIG. 6(b), a straight line that approximates the portion from -800 (Oe) to 0 (Oe) of the graph for the case of change from +1500 (Oe) to -1500 (Oe) is y=806.5x+871717. In FIG. 6(c), a straight line that approximates the portion from -800 (Oe) to 0 (Oe) of the graph for the case of change from +1500 (Oe) to -1500 (Oe) is y=174.6x+170187. y is the sum of squared differences, and x is the applied magnetic field.

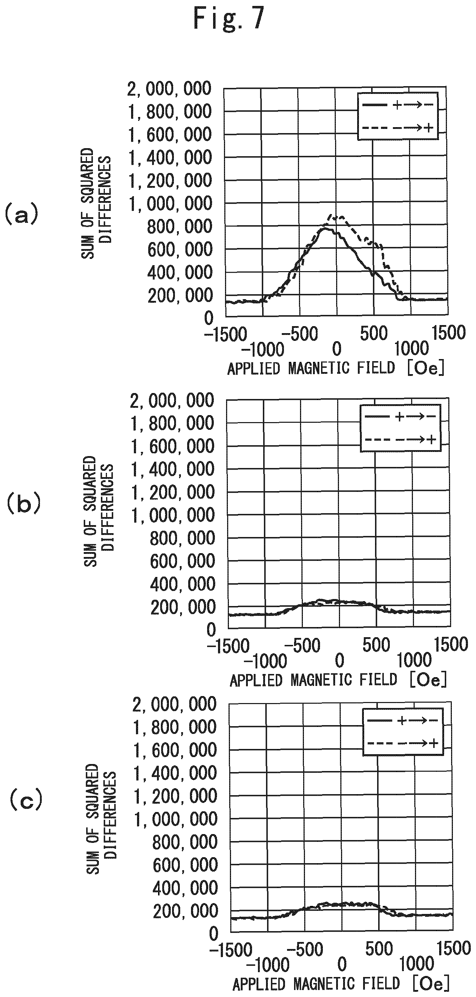

FIG. 7 shows the case where an 89-µm-thick rare-earth iron garnet film is used. FIGs. 7(a), 7(b), and 7(c) show graphs of the sum of squared differences with respect to the applied magnetic field for the cases where the field of view is 100 µm, 80 µm, and 30 µm, respectively. The graphs in FIGs. 7(a) to 7(c) are the results of measurements similar to those in FIGs. 6(a) to 6(c).

In FIG. 7(a), a straight line that approximates the portion from -800 (Oe) to 0 (Oe) of the graph for the case of change from +1500 (Oe) to -1500 (Oe) is y=212.0x+396014. In FIG. 7(b), a straight line that approximates the portion from -800 (Oe) to 0 (Oe) of the graph for the case of change from +1500 (Oe) to -1500 (Oe) is y=126.3x+250729. In FIG. 7(c), a straight line that approximates the portion from -800 (Oe) to 0 (Oe) of the graph for the case of change from +1500 (Oe) to -1500 (Oe) is y=14.3x+33211.

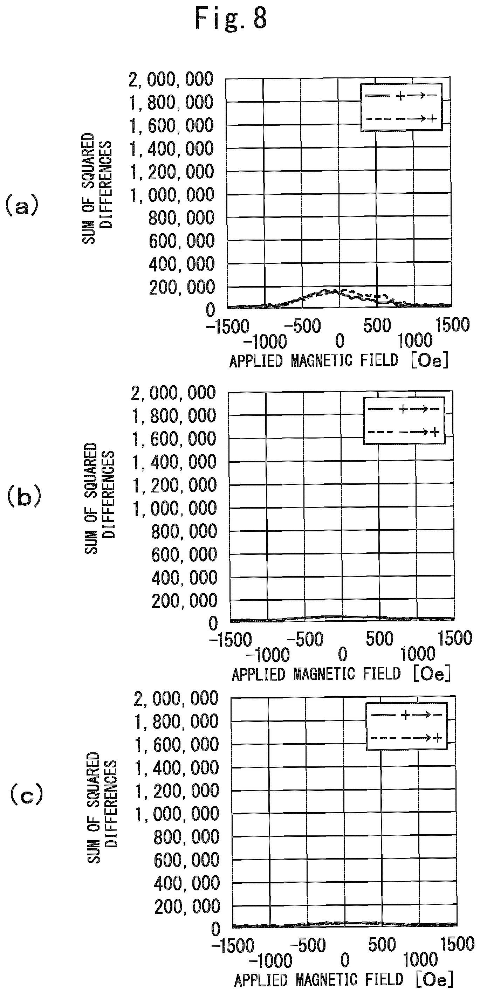

FIG. 8 shows the case where a 126-µm-thick rare-earth iron garnet film is used. FIGs. 8(a), 8(b), and 8(c) show graphs of the sum of squared differences with respect to the applied magnetic field for the cases where the field of view is 100 µm, 80 µm, and 30 µm, respectively. The graphs in FIGs. 8(a) to 8(c) are the results of measurements similar to those in FIGs. 6(a) to 6(c).

In FIG. 8(a), a straight line that approximates the portion from -800 (Oe) to 0 (Oe) of the graph for the case of change from +1500 (Oe) to -1500 (Oe) is y=218.5x+403287. In FIG. 8(b), a straight line that approximates the portion from -800 (Oe) to 0 (Oe) of the graph for the case of change from +1500 (Oe) to -1500 (Oe) is y=140.8x+257528. In FIG. 8(c), a straight line that approximates the portion from -800 (Oe) to 0 (Oe) of the graph for the case of change from +1500 (Oe) to -1500 (Oe) is y=21.1x+35513.

FIG. 9 shows evaluations of magnetic field sensors for the case where the three types of rare-earth iron garnet films with different thicknesses shown in FIGs. 6 to 8 are used as the magnetic film 34 in the magnetic field sensor device 1 shown in FIG. 1.

When making the evaluations shown in FIG. 9, each rare-earth iron garnet film was formed into a piece 125 µm by 125 µm and joined to the tip of the GI fiber 33. In addition, the length of the GI fiber 33 was adjusted, so that the diameters of beams emitted from the second PMF 32 were 100 µm, 80 µm, and 30 µm.

FIG. 9 shows the results of comparison of the magnetic field sensor device 1 shown in FIG. 1 with a reference sensor about the change in magnetic field in response to a rise of a pulse current; the magnetic field sensor device includes the GI fiber 33 adjusted so as to have the three different beam diameters for the magnetic films 34 made of the three types of rare-earth iron garnet films with different thicknesses. The results of comparison shown in FIG. 9 were made based on the results of measurements of the change in magnetic field in response to a rise of a 100-A pulse current flowing through a given electric wire, using the magnetic field sensor device shown in FIG. 1 with the magnetic film 34 and a reference sensor device. The rise time of the pulse current is several nanoseconds. The magnetic field sensors shown in FIGs. 6 to 8 were evaluated according to the degree of agreement of the change in magnetic field in response to a rise of the pulse current with that of the reference sensor.

In FIG. 9, "⊚" (double circle) indicates that the magnetic field could be measured very well, "o" (circle) indicates that the magnetic field could be measured well, "△" (triangle) indicates that the magnetic field could be measured to a certain extent, and "x" (cross) indicates that the magnetic field could not be measured well. The slopes of approximate curves of the graphs are also listed together with the evaluations.

When the evaluations in FIG. 9 are compared with the graphs in FIG. 6 to FIG. 8, it can be understood that the slopes of approximate curves of the graphs in FIGs. 6 to 8 correspond to the evaluations of the magnetic field sensors. This is because if the value of the sum of squared differences changes large enough (if the slope of the approximate line is large enough) in response to a change in an applied magnetic field, the magnetic field sensor will work satisfactorily. Thus, when the slope of the sum of squared differences of the rare-earth iron garnet film with respect to an applied magnetic field is 100 or greater, the film will be satisfactorily used for the magnetic field sensor device 1. In this case, the thickness of the rare-earth iron garnet film is preferably between 51 µm and 126 µm inclusive, and the diameter of a beam outputted from the GI fiber 33 is preferably between 30 µm and 100 µm inclusive. The diameter of a beam outputted from the GI fiber 33 is less than or equal to the diameter of the GI fiber 33.

It should be understood that without departing from the scope of the present invention, those skilled in the art may make various changes, substitutions, and modifications thereto. For example, the embodiment and modified examples described above may be combined as appropriate within the scope of the present invention.

### REFERENCE SIGNS LIST

- 1: magnetic field sensor device
- 10: light emitter
- 20: optical splitter
- 30: magnetic field sensor head
- 33: GI fiber
- 34: magnetic film
- 40: detection signal generator
- 410: field of view

## Claims

1. A magnetic sensor head comprising:
an optical fiber;
a GI fiber having one end optically connected to the optical fiber;
a magnetic film joined to the other end of the GI fiber; and
a reflective film joined to a surface of the magnetic film opposite a surface joined to the GI fiber, wherein
the magnetic film is formed of a rare-earth iron garnet film, and
the slope of the sum of squared differences of the rare-earth iron garnet film with respect to an applied magnetic field is 100 or greater.

2. The magnetic sensor head according to claim 1, wherein the thickness of the rare-earth iron garnet film is between 51 µm and 126 µm inclusive.

3. The magnetic sensor head according to claim 1 or 2, wherein the diameter of a beam emitted from the GI fiber to the magnetic film is between 30 µm and 100 µm inclusive.

4. A magnetic film used for a magnetic sensor head including an optical fiber, a GI fiber having one end optically connected to the optical fiber, and a reflective film, the magnetic film having
one surface joined to the GI fiber, and
the other surface joined to the reflective film, wherein
the magnetic film is formed of a rare-earth iron garnet film, and
the slope of the sum of squared differences of the rare-earth iron garnet film with respect to an applied magnetic field is 100 or greater.
